# EUROPEAN PATENT SPECIFICATION

(11) **EP 0 595 502 B1**
(45) Date of publication and mention of the grant of the patent: **23.09.1998**
(21) Application number: 93308152.3
(22) Date of filing: 13.10.1993
(51) Int. Cl.: H01S 3/025

(54) **Semiconductor optical apparatus having an improved precision for the optical beam position**
Optische Halbleitervorrichtung mit verbesserter Positionierung des optischen Strahls
Appareil optique à semiconducteur avec une précision améliorée de la position du faisceau optique

(30) Priority: 14.10.1992 JP 276305/92
(43) Date of publication of application: 04.05.1994
(73) Proprietor: FUJITSU LIMITED, Kawasaki-shi, Kanagawa 211 (JP)
(72) Inventor: Makita, Akihiko, c/o Fujitsu Limited, Kawasaki-shi, Kanagawa 211 (JP); Ichihara, Junichi, c/o Fujitsu Limited, Kawasaki-shi, Kanagawa 211 (JP)
(74) Representative: Gibbs, Christopher Stephen

(56) References cited:
- EP-A- 0 259 816
- GB-A- 2 017 958
- US-A- 5 136 152
- PATENT ABSTRACTS OF JAPAN vol. 10, no. 69 (E-389)(2126) 18 March 1986 & JP-A-60 219 788 (FUJI XEROX) 2 November 1985
- PATENT ABSTRACTS OF JAPAN vol. 9, no. 270 (E-353)26 October 1985 & JP-A-60 113 978 (SUMITOMO DENKI) 20 June 1985
- PATENT ABSTRACTS OF JAPAN vol. 14, no. 344 (E-955)25 July 1990 & JP-A-02 116 186 (NEC) 27 April 1990
- PATENT ABSTRACTS OF JAPAN vol. 9, no. 302 (E-362)(2025) 29 November 1985 & JP-A-60 140 775 (NIPPON DENKI) 25 July 1985

## Description

The present invention generally relates to semiconductor optical apparatuses, and more particularly to a semiconductor optical apparatus that includes therein a laser diode and which is adapted for mounting upon a host apparatus.

Various electronic apparatuses use a laser diode. For example, laser diodes are used in optical disk devices, laser printers and optical telecommunication apparatus.

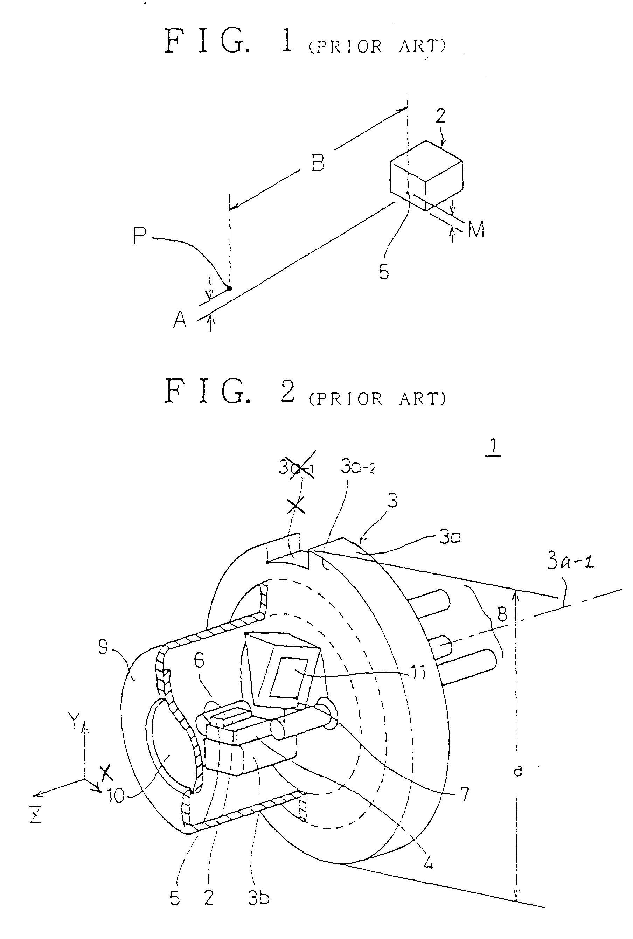

When using a laser diode, an example of which is shown in Fig. 1 of the accompanying drawings by numeral 2, in such electronic apparatuses, it is necessary to determine the position of the luminous spot (designated in Fig. 1 by numeral 5) with high precision,
particularly with respect to the expected beam position (designated by P). Preferably, the offset A in Fig. 1, indicating the deviation of the optical axis, is set below a few microns. Similarly, the offset B in the axial direction should be set below a few microns.

Thus, it is necessary to fabricate the laser diode with high precision in terms of the outer dimensions.

Further, the laser diode is required to have a compact size.

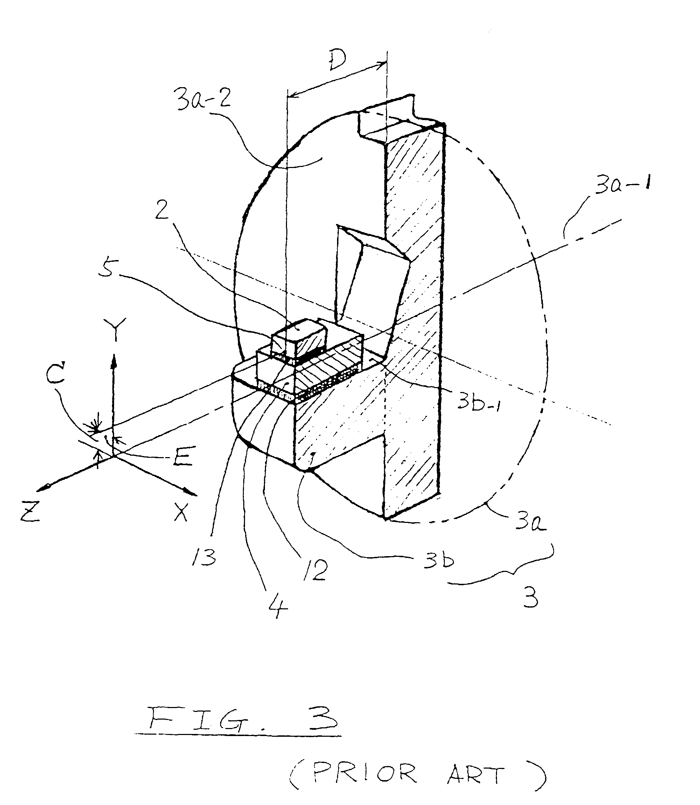

Figs. 2 and 3 of the accompanying drawings show an example of a previously-considered (conventional) laser diode assembly 1, which includes a laser diode 2 mounted within a metal case 3.

The case 3 is formed by machining and includes a disc part 3a and a projecting part 3b projecting from the disk part 3a.

As shown in Fig. 2, the disc part 3a is formed so as to be generally symmetrical with respect to a center line 3a₋₁ and has a surface 3a₋₂ that acts as a reference surface when mounting the laser diode assembly 1 on other apparatus.

It will be noted that the projecting part 3b carries thereon a heat sink 4, and the laser diode 2 is mounted upon the heat sink 4. In Fig. 2, the edge of the laser diode 2 from which the optical beam is emitted is designated by a numeral 5. Hereinafter, the edge 5 will be referred to as a luminous spot.

The apparatus of Fig. 2 also includes lead wires 6 and 7 as well as electrode pins 8 for external connection, and the laser diode 2 is protected by a cap 9 that is formed with a window 10 through which the optical beam passes. Further, there is provided an optical detector 11.

Referring to Fig. 3, it will be noted that the heat sink 4 is mounted upon the projecting part 3b₋₁ by a braze alloy layer 12, and the laser diode 2 itself is also mounted upon the heat sink 4 by another braze alloy layer 13.

In the laser diode assembly 1 having such a construction, it is desirable to produce dimensions C, D and E as accurately as possible, preferably within the order of microns. The dimensions C and E represent the distance of the luminous spot 5 as measured from the centre line 3a₋₁ in the Y- and X-directions respectively, while the dimension D represents the distance in the Z-direction of the luminous spot 5 from the reference surface 3a₋₂.

In the structure of Fig. 3, it will be noted that, because of the existence of the heat sink 4 and associated braze layers 12 and 13, there is a tendency that the distance C varies in the order of 100 µm even when the position of the projecting part 3b is determined with a high precision.

Similarly, there is a tendency that the dimensions D and E vary in the Z- and X-directions respectively in the order of 100 µm, due to the deviation associated with the mounting of the laser diode 2 upon the heat sink 4.

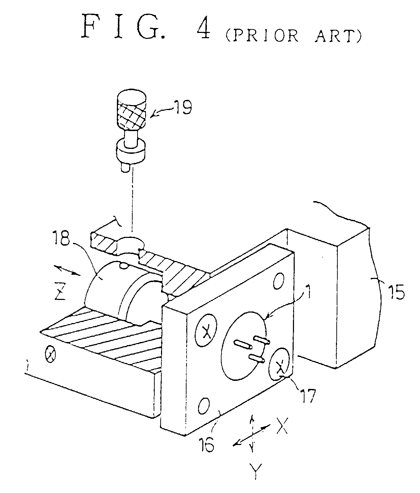

In order to overcome the foregoing problem, the laser diode assembly 1 can be mounted on an external host apparatus such as an optical disk apparatus 15 with an adjusting mechanism as shown in Fig. 4.

Referring to Fig. 4, the laser diode assembly 1 is mounted upon a slidable plate 16 that acts as the adjusting mechanism, wherein the slidable plate 16 is mounted upon the external apparatus 15 by means of a screw 17. When mounting the laser diode assembly 1 upon the apparatus 15, the position of the apparatus 1 is adjusted in the X- and Y-directions to minimize the deviation for the dimensions C and E.

Further, the deviation with respect to the dimension D is compensated for by moving a collimator lens 18 in the Z-direction by actuating an eccentric cam 19.

Such a previously-considered (conventional) laser diode assembly has an obvious drawback in that the apparatus requires a complicated adjusting process as well as mechanism when mounting upon the external apparatus 15. When the apparatus 15 is an optical pickup device, for example, such an adjusting process increases the number of steps that are needed to assemble the optical pickup device. Further, such a complex adjusting mechanism increases the size of the optical pickup device.

Further, it should be noted that the disk part 3a forming the case 3 of the apparatus 1 generally has a large diameter d which is as large as about 10 mm. Thereby, the apparatus 1 inevitably has a large size.

It is a general object of the present invention to provide a novel and useful optical semiconductor apparatus wherein the foregoing problems are eliminated.

It is also another more specific object of the present invention to provide an optical semiconductor apparatus including a laser diode wherein the positional precision of the laser diode is substantially improved.

According to a first aspect of the present invention there is provided an optical semiconductor apparatus, adapted for mounting on an external apparatus, comprising: a case having a first surface adapted for engagement with said external apparatus, a second surface which is parallel to the first surface and separated from the said first surface by a distance, and a cavity formed by a depression on said second surface; a subcarrier member having a principal surface; and a laser diode mounted on the said principal surface of the said subcarrier member for producing an optical beam; the said subcarrier member being mounted in the semiconductor apparatus such that the said principal surface thereof is held in an abutting relationship with the said second surface of the said case, and the said laser diode is accommodated within said cavity; characterised in that the laser diode is arranged on the subcarrier member such that the laser beam is emitted parallel to the said principal surface; and in that said distance is predetermined and chosen such that a desired distance of the laser diode from the said first surface is automatically achieved when the said subcarrier member is mounted on the said second surface; and in that the structure of the case and the cavity are such that the said subcarrier member is movable in a direction parallel to the said principal surface thereof during such positioning of the laser diode, while said principal surface is held in abutting engagement with the said second surface for accurately positioning the laser diode.

According to a second aspect of the present invention there is provided a method of producing an optical semiconductor apparatus adapted for mounting on an external apparatus, which method comprises the steps of: forming, on a case having a first surface for engagement with said external apparatus, a second surface, which is parallel to the first surface and separated from the said first surface by a distance, and a cavity formed by a depression on said second surface; attaching a laser diode for producing an optical beam to a principal surface of a subcarrier member; and attaching the said subcarrier member to the case such that the said principal surface thereof is held in an abutting relationship with the said second surface of the said case and the said laser diode is accommodated within the cavity; characterised in that the laser diode is attached such that the optical beam is emitted parallel to the said principal surface; land in that said distance is predetermined and chosen such that a desired distance of the laser diode from the said first surface is automatically achieved when the subcarrier member is mounted on the said second surface; and in that the said first and second surfaces of the case serve as reference surfaces for use in accurately positioning the laser diode, when attached to the said subcarrier member, in the semiconductor apparatus prior to attachment of the said subcarrier member to the said case; the method being further characterised by the additional steps, carried out between the steps of attaching the laser diode to the subcarrier member and attaching the subcarrier member to the case, of: energizing the said laser diode so that an optical beam is produced thereby; and
adjusting the position of the said subcarrier member, while maintaining the said principal surface in abutting engagement with the said second surface, until the said optical beam travels along a predetermined path.

Thus, the position of the principal surface of the subcarrier member may be determined exactly with respect to the first surface of the case, due to the abutted engagement of the subcarrier member with the second surface of the case whilst the subcarrier member is moved in a direction parallel to its principal surface. Thereby, the position of the laser diode held upon the principal surface of the subcarrier member is determined exactly with reference to the first surface and hence the external apparatus. It should be noted that the subcarrier member acts also as a heat sink for dissipating heat from the laser diode to the case.

JP-A-60-219788 and JP-A-2-116186 disclose optical devices comprising: a body member having a first surface, a second surface which is separated from the said first surface, and a cavity; a subcarrier member having a principal surface; and a laser diode mounted on the said principal surface of the said subcarrier member; the said subcarrier member being mounted in the device such that the said principal surface thereof is held in an abutting relationship with the said second surface of the said body member and the said laser diode is accommodated within the said cavity.

In embodiments of the present invention, it is possible to reduce the number of parts of the apparatus while maintaining a high precision for the laser diode and the optical beam produced from the laser diode.

Reference will now be made, by way of example, to the accompanying drawings, in which:
Fig. 1 (described above) is a diagram showing the relationship between a laser diode and an optical beam produced from the laser diode;
Fig. 2 (described above) is a diagram showing the construction of a previously-considered (conventional) laser diode assembly;
Fig. 3 (described above) is a diagram showing the laser diode assembly of Fig. 2 in a cross-sectional view;
Fig. 4 (described above) is a diagram showing an adjusting mechanism used with the laser diode assembly of Fig. 2 for adjusting the position of the optical beam produced therefrom;
Figs. 5 - 8 are diagrams showing an optical semiconductor apparatus (laser diode assembly) according to a first embodiment of the present invention;
Fig. 9 is a diagram showing electrical connection in the laser diode assembly of the first embodiment;
Fig. 10 is a diagram showing a subcarrier used in the laser diode assembly of the first embodiment;
Fig. 11 is a diagram showing a modification of the laser diode assembly of the first embodiment;
Fig. 12 is a diagram illustrating the assembly of the laser diode assembly of the first embodiment;
Fig. 13 is a diagram showing the laser diode assembly of the first embodiment when the subcarrier is incorporated into a case of the apparatus;
Fig. 14 is a diagram showing an optical semiconductor apparatus (laser diode assembly) according to a second embodiment of the present invention;
Fig. 15 is a diagram showing an optical semiconductor apparatus (laser diode assembly) according to a third embodiment of the present invention;
Fig. 16 is a diagram showing the mounting of the laser diode assembly of the first embodiment on an optical pickup device;
Fig. 17 is a diagram showing the construction of an optical semiconductor apparatus (laser diode assembly) according to a fourth embodiment of the present invention;
Fig. 18 is a diagram showing the laser diode assembly of Fig. 17 in a cross-sectional end view;
Fig. 19 is a diagram showing the construction of an optical semiconductor apparatus (laser diode assembly) according to a fifth embodiment of the present invention;
Figs. 20(a) and 20(b) are diagrams showing the construction of a subcarrier member for use in the embodiment of Fig. 19;
Figs. 21(a) and 21(b) are diagrams showing the construction of another subcarrier member for use in the embodiment of Fig. 19;
Fig. 22 is a diagram showing the construction of an optical semiconductor apparatus (laser diode assembly) according to a sixth embodiment of the present invention;
Fig. 23 is a diagram showing suction apparatus used for assembling the device of Fig. 22; and
Fig. 24 is a diagram showing the construction of an optical semiconductor apparatus (laser diode assembly) according to a seventh embodiment of the present invention.

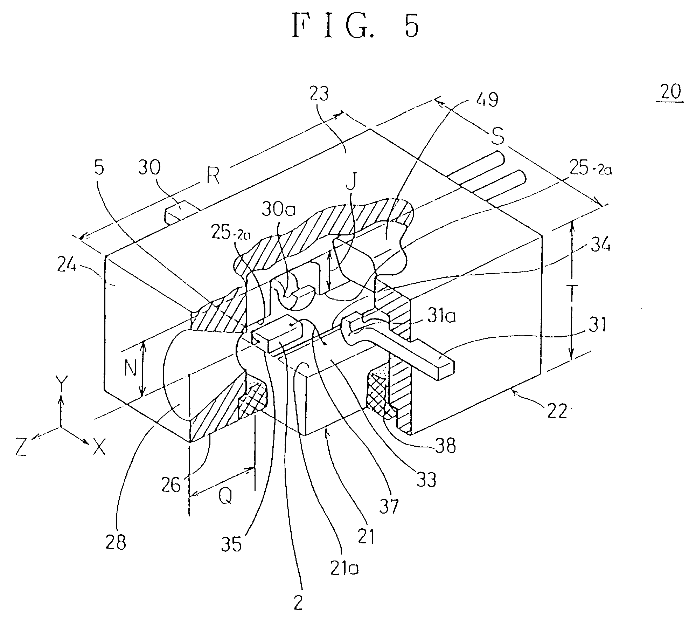

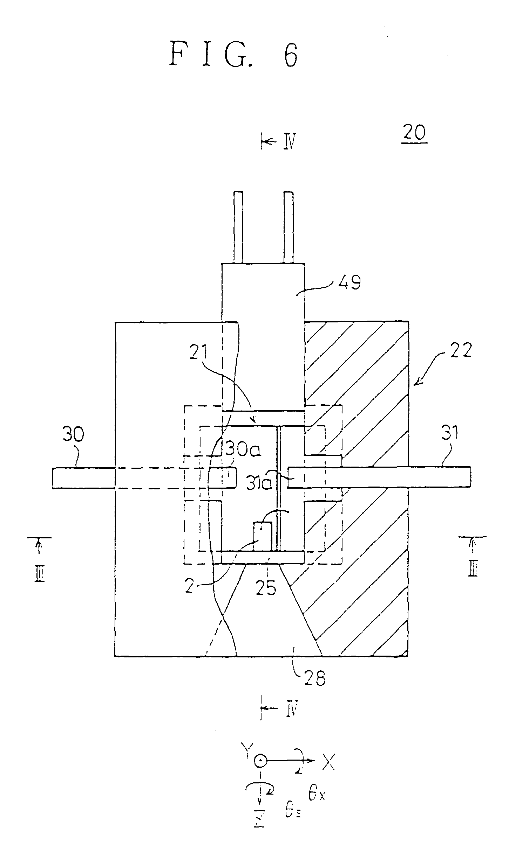

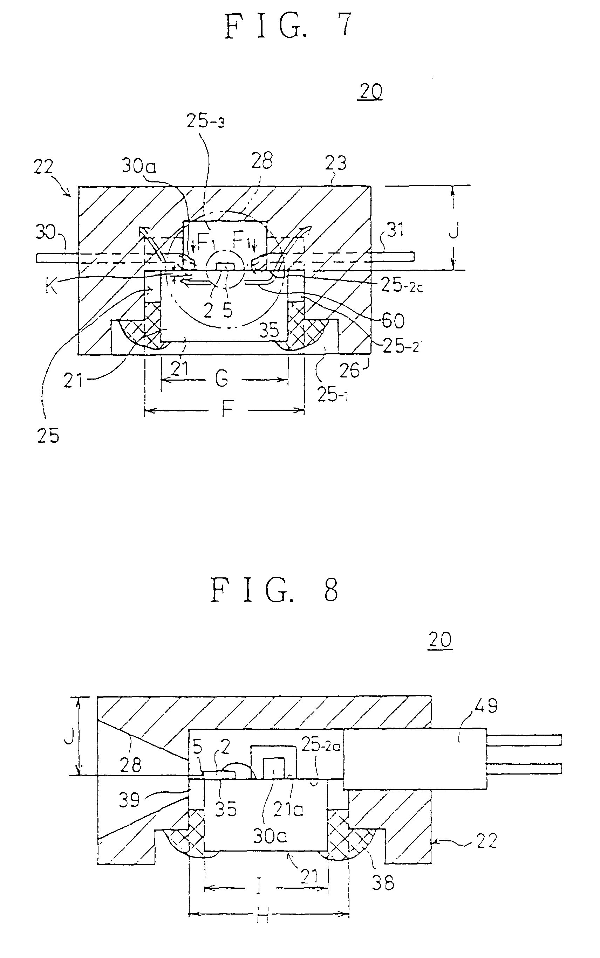

Figs. 5 - 8 show a laser diode assembly 20 according to a first embodiment of the present invention. Fig. 5 shows a partial cross-sectional perspective view of the laser diode assembly 20, Fig. 6 shows a partial cross-sectional plan view, Fig. 7 shows a cross-sectional end view, and Fig. 8 shows a cross-sectional side view.

Referring to the drawings, the laser diode assembly includes a subcarrier member 21, which carries thereon a laser diode 2, and a case (body base) 22 of the apparatus which carries the subcarrier member 21.

The case 22 may be formed of aluminum having an anodized protection coating, a heat resistant plastic or a ceramic, and typically has a rectangular, or cuboid, shape.

The case 22 has an upper major surface 23 which acts as a first reference surface when the laser diode assembly is mounted on an external apparatus.

The case 22 also has a front surface 24 which acts as a front reference surface when the apparatus is mounted on an external apparatus.

In addition, the case 22 has a cavity 25 formed in its bottom surface 26, the depth of the cavity 25 increasing in steps towards the central part of the bottom surface 26.

The cavity 25 includes a first depression part 25₋₁, which has a size large enough to allow insertion of a manipulation hand (to be described later), and a second depression part 25₋₂ formed generally at a central region of the first depression part 25₋₁, which second depression part 25₋₂ has an increased depth as compared with the depth of the depression part 25₋₁. The depression part 25₋₂ has transversal and longitudinal sizes F and H larger than corresponding transversal and longitudinal sizes G and I of the subcarrier member 21 (to be described later). Further, the cavity 25 has a third depression part 25₋₃ located in correspondence with the central part of the second depression part. The third depression part 25₋₃ is used to accommodate as laser diode, as will be described later.

In such a structure, a bottom surface 25₋₂ₐ of the second depression part 25₋₂ forms a second reference surface separated from the first reference surface 23 by a predetermined distance J. The position of the bottom surface 25₋₂ₐ, and hence the distance J, is determined within the precision of a few microns.

A tapered aperture 28 penetrates through the case 22 from the front reference surface 24 to the third depression part 25₋₃, to provide a passage for a laser beam produced by the laser diode 2.

Further, electric contact leads 30 and 31 are provided which have respective inner ends 30a and 31a encapsulated within the case 22 by a glass, while outer ends of the leads 30 and 31 protrude laterally from the case 22.

The inner ends 30a and 31a are resilient and protrude into the depression part 25₋₃, toward the reference surface 25₋₂ₐ. When in a free state, the inner ends 30a and 31a cross the reference surface 25₋₂ₐ by a distance K as indicated in Fig. 7 by a broken line.

A subcarrier member 21 is formed of an insulating material having simultaneously a high thermal conductivity. Preferably, the subcarrier member 21 is formed of a ceramic material such as aluminum nitride or boron nitride, or alternatively of silicon having an insulative coating. Typically, a subcarrier member 21 has a rectangular shape and acts as a base as well as a heat sink of the laser diode 2.

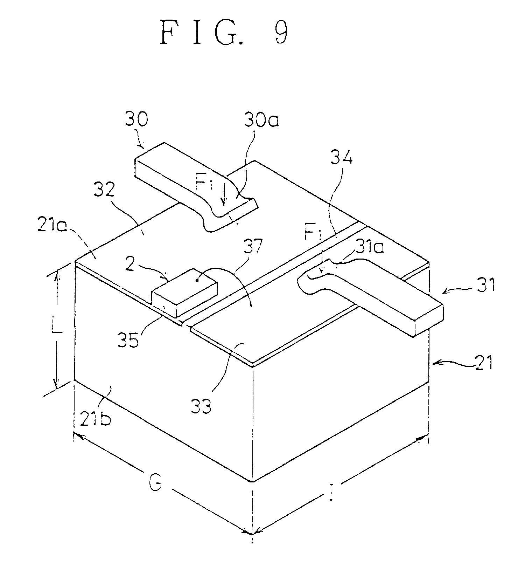

As indicated in Fig. 9, the subcarrier member 21 has a lateral size G, a longitudinal size I and a height L, each of which are in the order of several millimetres, and hence is suitable for manual manipulation. As noted before, the subcarrier member 21 is slightly smaller in size than the depression part 25₋₂.

The subcarrier member 21 has an upper major surface 21a on which electrode films 32 and 33 are provided, with an intervening insulation part 34 formed therebetween.

A laser diode 2 is provided on the upper major surface 21a of the subcarrier member 21 adjacent to an end edge 21b thereof. The laser diode 2 is brazed onto the electrode film 32 via a solder layer 35.

A lead wire 37 establishes an electrical connection between an upper surface of the laser diode 2 and the electrode film 33.

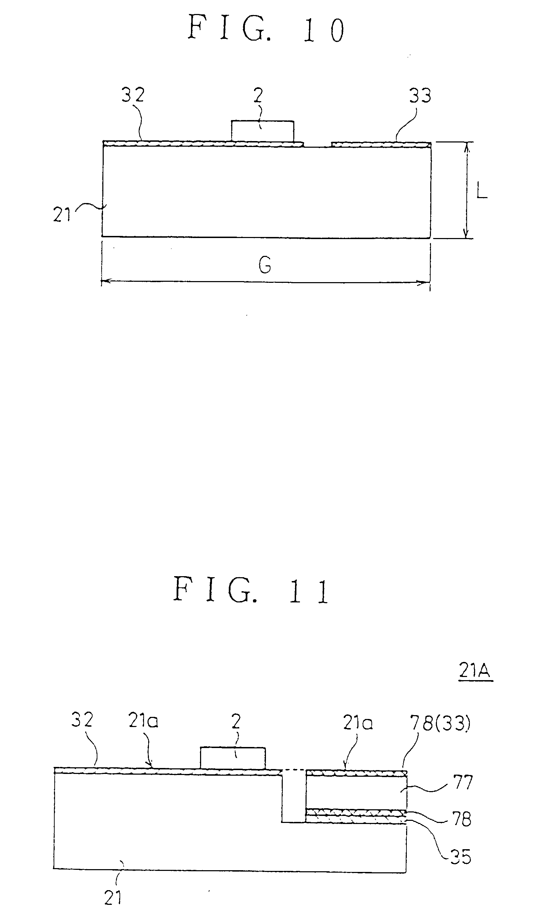

Fig. 10 shows a vertical cross-sectional end view of the subcarrier 21. The two electrodes of the laser diode 2, respectively carried on the upper and lower surfaces of the laser diode 2, are connected respectively to the electrode film 32 and the electrode film 33. The electrode film layers 32 and 33 have a reliable electrical insulation therebetween.

Fig. 11 is a diagram corresponding to Fig. 10, but shows a cross-sectional view of a carrier member 21a made of copper. In the embodiment of Fig. 11, the electrode film 33 is formed on a ceramic insulating base 77 in order to achieve electrical insulation between the electrode film 32 and the electrode film 33. It should be noted that insulating base 77 carries a metal layer 78 on the upper and lower major surfaces thereof; the lower metal layer 78 being brazed onto the copper base 21 via a braze alloy layer 35, and the upper metal layer 78 acting as the electrode film 33.

In order to maintain the level of the upper major surface 21a substantially flush between the copper base 21 and the ceramic base 77, the upper major surface of the subcarrier 21a is polished after the insulating base 77 is mounted upon the copper base 21.

The subcarrier member 21 is mounted on the case 22 such that the surface 21a that carries the laser diode 2 abuts against the reference surface 25₋₂ₐ. The periphery of the member 21 is fixed upon the case 22 permanently by an adhesive 38 to maintain the abutting engagement.

It should be noted that the laser diode 2 is formed by an epitaxial process. Therefore, the distance between a surface 2a of the laser diode 2 that is brazed upon the subcarrier member and the luminous spot 5 shown in Fig. 1 is determined with high precision. In Fig. 1, the foregoing distance is designated as M.

Thus, the distance N designated in Fig. 5 between the reference surface 23 and the luminous spot 5 can be determined with the precision of a few microns by simply mounting the subcarrier member 21 on the case 22.

Further, as a result of the positional adjustment to be described later, one can determine the distance Q between the front reference surface 24 and the luminous point 5 precisely to within a few microns.

The inner ends 30a and 31a of the leads 30 and 31 are urged by the subcarrier 21 upon the mounting of the subcarrier 21 on the case 22, and the electrodes 30 and 31 are urged to the electrode films 32 and 33 as a result of the resilient for F₁ thus built up in the electrodes 30 and 31.

Referring to Fig. 5 again, there is provided a monitor photodetector 49 that is mounted upon the case 22.

The laser diode assembly 20 of the foregoing construction typically has an overall longitudinal length R and an overall transversal width S of about 4 mm, and an overall height T of about 2 mm. Thereby, the laser diode assembly 20 has a substantially reduced size as compared with previously-considered (conventional) laser diode assemblies.

Adjustment of a laser diode assembly embodying the present invention during assembly thereof will now be described.

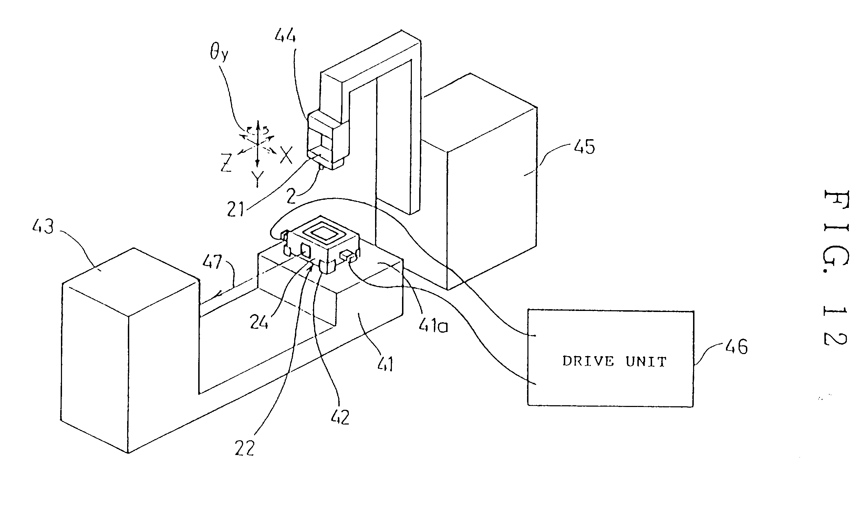

Fig. 12 shows a jig 40 used for such an assembly process.

Referring to Fig. 12, the jig 40 includes a base 41 and a positioning part 42 formed on the base 41. The numeral 43 denotes an optical detector, and the numeral 44 represents a manipulation hand used for clamping the foregoing subcarrier member 21.

The manipulation hand 44 is driven by a drive unit 45 that moves the hand 44 in the X-, Y- and Z-directions as indicated by arrows. Further, the hand 44 is rotatable about the Y-axis as indicated by θy.

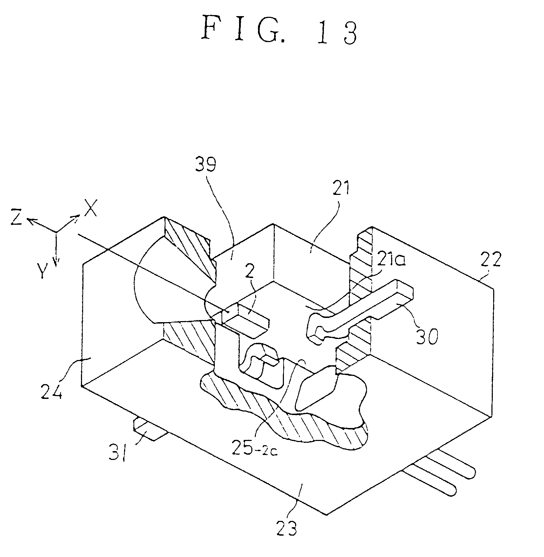

When assembling the apparatus 20, the empty case 22 is placed upside down, as indicated in Fig. 13, on the base 41 such that the reference surface 23 contacts an upper major surface 41a of the base 41. Further, the position of the case 22 is determined by abutting the front reference surface 24 against the positioning part 42.

A laser driving power unit 46 is connected to the lead electrodes 30 and 31.

The hand 44 holds the subcarrier member 21, that in turn carries thereon the laser diode, and the hand 44 lowers the subcarrier member 21 (in the Y-direction), such that the subcarrier member 21 is accommodated within the cavity 25 formed in the case 22. The upper major surface 21a of the subcarrier member 21 is abutted against the reference surface 25₋₂ₐ.

In this state, the laser diode 2 is driven and a laser beam 47 is produced in response thereto.
Thereby, the laser beam 47 enters the photodetector 43 via the aperture 28 mentioned previously.

Next, the manipulation hand 44 is driven in the Z-, X- and θy-directions while monitoring the output of the photodetector 43, such that the subcarrier 21 is moved by a minute distance in the X-Z plane in search of the maximum of the output of the photodetector 43. Upon detection of the maximum, the driving of the hand is stopped and the subcarrier member 21 is fixed on the case 22 by applying the adhesive 38 such that the adhesive 38 fills the gap 39 between the periphery of the subcarrier member 21 and the depression part 25₋₂.

As a result of the foregoing assembling process, the subcarrier member 21 is fixed permanently on the case 22 of the laser diode assembly 20 in the state that the position of the luminous point 5 of the laser diode 2 is determined with a high precision with respect to the reference surfaces 23 and 24.

It should be noted that the first depression part 25₋₁ has a size large enough to accept the manipulation hand 44. Further, the second depression part 25₋₂ is formed so as to be of a size allowing the lateral movement of the subcarrier member 21. Thus, the positional adjustment of the subcarrier member 21 can be achieved without the problems associated with previously-considered constructions of laser diode apparatus.

Alternatively, one may avoid turning the case 22 upside down, when mounting on the base 41, by using a vacuum suction mechanism.

In the above-described assembly process, it should be noted that it is not necessary for any positional adjustment to be made in the Y-direction, as the required positioning precision of the laser diode 2 is obtained by simply abutting the subcarrier member 21 against the case 22 as described above.

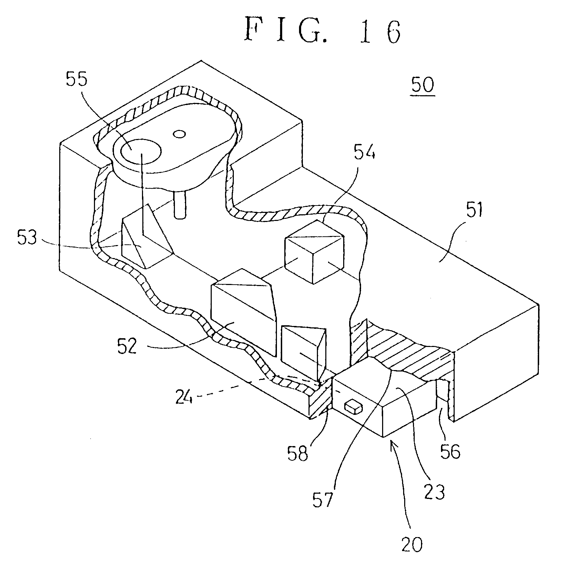

The laser diode assembly 20 thus assembled is mounted upon an external apparatus 50 such as an optical pickup device of an optical disk drive as shown in Fig. 16.

The optical pickup device 50 includes various optical elements such as a prism 52, a mirror 53, a beam splitter 54 and an objective lens 55 in a housing 51.

The housing 51 is formed with a mounting part 56 for mounting the laser diode assembly 20 thereon, the mounting part 56 including reference surfaces 57 and 58 for abutting engagement with the laser diode assembly 20. It should be noted that the housing 51 has a substantially reduced size as compared with the housing of previously-considered optical pickup devices, since the housing 51 does not use adjustment mechanisms for positional adjustment of the laser diode assembly 20.

In the optical pickup device 50, the optical elements such as the prism 52, the mirror 53, the beam splitter 54, the objective lens 55, and the like, are disposed with a predetermined positional relationship determined with respect to the reference surfaces 57 and 58.

When assembling the optical pickup device 50, the laser diode assembly 20 is mounted such that the reference surface 23 of the apparatus 20 establishes an abutting engagement with the reference surface 57 and such that the front reference surface 24 establishes an abutting engagement with the reference surface 58.

The position of the luminous spot 5 of the laser diode 2 can be determined exactly with reference to the reference surfaces 57 and 58, because of such a construction of the optical pickup device 50, and one can eliminate positional adjustment after the apparatus 20 is mounted upon the pickup device 50.

As a result, the efficiency for manufacturing the optical pickup device 50 can be increased substantially.

Furthermore, heat that is produced by the laser diode 2 during operation of the laser diode assembly 20 can be dissipated to the subcarrier member 21 as indicated in Fig. 7 by an arrow 61, and the heat can be dissipated further to the case 22 of the apparatus 20 through the abutting reference surfaces 21a and 25₋₂ₐ.

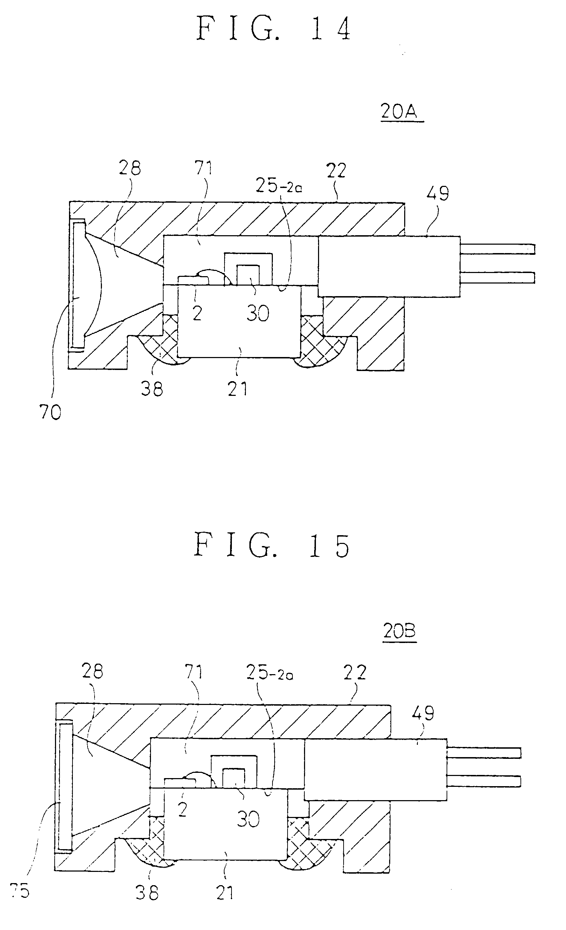

Fig. 14 shows a laser diode assembly 20A according to a second embodiment of the present invention.

Referring to Fig. 14, the apparatus 20A includes, in addition to the apparatus 20 of Fig. 5, a collimator lens 70 that is provided across the aperture 28, thereby forming a closed space 71 in which the laser diode 2 is accommodated.

Fig. 15 shows a laser diode assembly 20B according to a third embodiment of the present invention.

Referring to Fig. 15, the apparatus 20B uses a simple optical window 75 in place of the lens 70 of the apparatus 20A of Fig. 14.

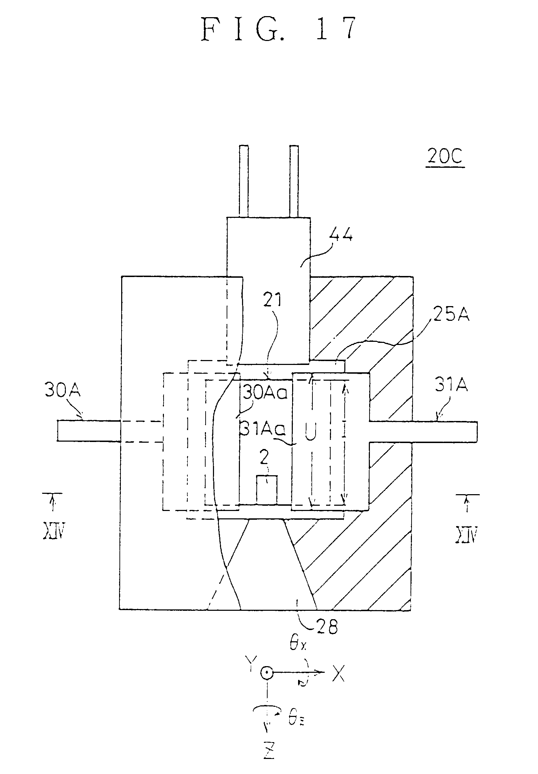

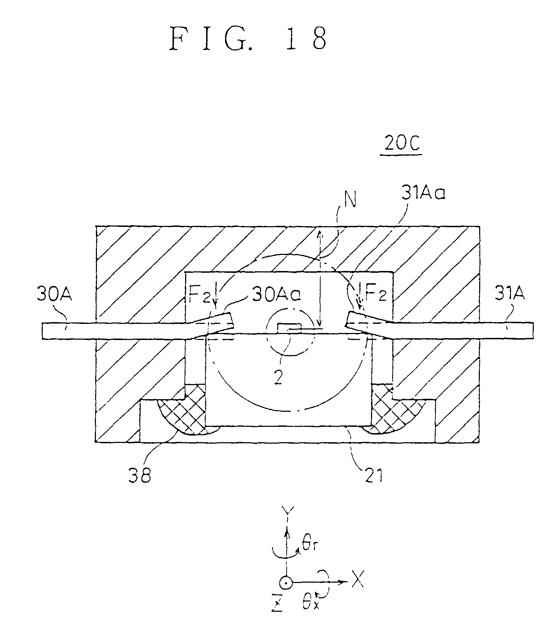

Figs. 17 and 18 show a laser diode assembly 20c according to a fourth embodiment of the present invention.

Referring to the drawings, the laser diode assembly 20c includes lead electrodes 30A and 31A having contact parts 30Aa and 31Aa at respective distal ends each having a width U corresponding to the size I of the subcarrier member 21.

When the subcarrier member 21 is not mounted on the case 22, the contact parts 30Aa and 31Aa assume the state shown in Fig. 18 by a broken line.

In the embodiment of Figs. 17 and 18, the subcarrier member 21 is accommodated in a cavity 25A formed in the case 22 of the apparatus 20c, which cavity 25A lacks the previously-considered reference surface 25₋₂ₐ.

In such a construction, the subcarrier member 21 is urged against the contact parts 30Aa and 31Aa as indicated in Fig. 17, and the contact parts 30Aa and 31Aa experience elastic deformation as a result. By adjusting the amount of the elastic deformation, one can adjust the position of the carrier member 21 in the Z- and X-directions as well as in the Y-direction. In other words, the construction of the present embodiment provides a possibility of three-dimensional adjustment of the subcarrier member 21.

More specifically, the present embodiment enables positional adjustment of the laser diode 2 with respect to the distance N shown in Fig. 18.

Further, it is possible to adjust the orientation of the laser diode not only about the Y-axis as represented by the rotational angle θy, but also about the X- and Z-axis as represented by the rotational angles θx and θz.

Fig. 18 shows the state wherein the subcarrier member 21 is fixed on the case of the apparatus 20C by adhesive when the contact parts 30Aa and 31Aa are deformed elastically so as to exert a force F₂ upon the member 21.

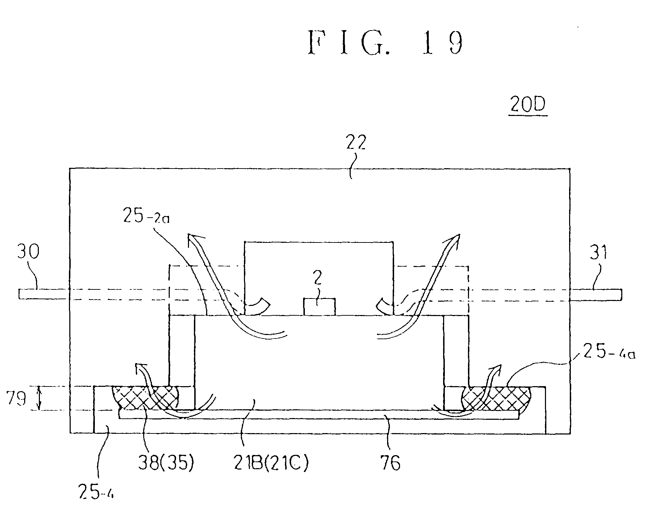

Fig. 19 shows a laser diode assembly 20D according to a fifth embodiment of the present invention in a cross-sectional view corresponding to Fig. 7.

Referring to Fig. 19, the apparatus 20D includes, in addition to the construction of the apparatus 20 of Fig. 5, a metal sheet 76 and a further depression part 25₋₄ for accepting the metal sheet 76.

The metal sheet 76 may be formed of a metal such as copper or phosphor bronze, or a heat conductive plastic having a metal coating of gold, silver or copper thereon.

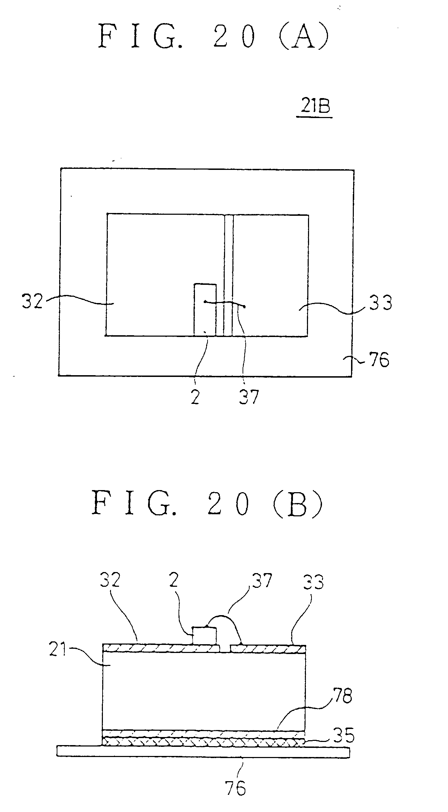

Figs. 20(A) and 20(B) show plan and side views respectively of a subcarrier member 21B corresponding to the subcarrier member 21 of Fig. 10. It will be noted that the subcarrier 21b includes a metal layer 78 on the lower major surface thereof, and a metal sheet 76 is mounted upon the metal layer 78 via a braze alloy 35.

As will be see from Fig. 20(A), the subcarrier 21b is held substantially at the central part of the metal sheet 76.

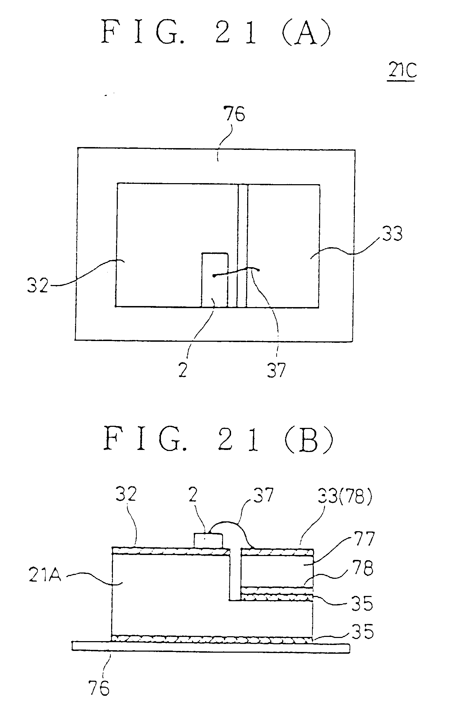

Figs. 21(A) and 21(B) shows views of a subcarrier member 21C corresponding to the subcarrier member 21A of Fig. 11. As will be seen from the side view of Fig. 21(B), the subcarrier member 21C is formed by simply attaching a metal sheet 76 to the subcarrier 21A via a braze layer 35.

As can be seen in Fig. 21(A), it will be noted that the subcarrier 21C is held generally at the central part of the metal sheet 76.

The subcarrier member 21B or 21C can be mounted upon the case 22 of the laser diode assembly 20 by fixing the metal sheet 76 on the depression part 25₋₄ by means of the adhesive 35 or 38. In the construction of Fig. 19, it will be noted that one can reduce the amount of the adhesive as a result of the reduced gap 79. Thereby, the efficiency of dissipation of heat from the subcarrier member 21B or 21C to the case 22 is maximized by providing a path through the adhesive 38, in addition to the path in which the heat is dissipated directly from the carrier member 21B to the case 22. The efficiency of heat dissipation is further increased by employing a braze alloy having a large thermal conductivity in place of the adhesive 35 or 38.

The construction of Fig. 19 has another advantageous feature in that all of the peripheral part of the metal sheet 76 is fixed to the case 22. Consequently, a large area of the metal sheet 76 is attached to the case 22, in spite of the fact that the size of the subcarrier member 21 itself is small. Accordingly, the metal sheet 76 is reliably adhered to the case 22, and the efficiency of heat dissipation through the sheet 76 is improved substantially.

In the structure of Fig. 19, it should be noted that the size of the gap 79, formed between the metal sheet 76 and the surface 25₋₄ₐ and filled by the braze alloy or adhesive, is small, so that heat may dissipate relatively easily through the material filling the gap 79.

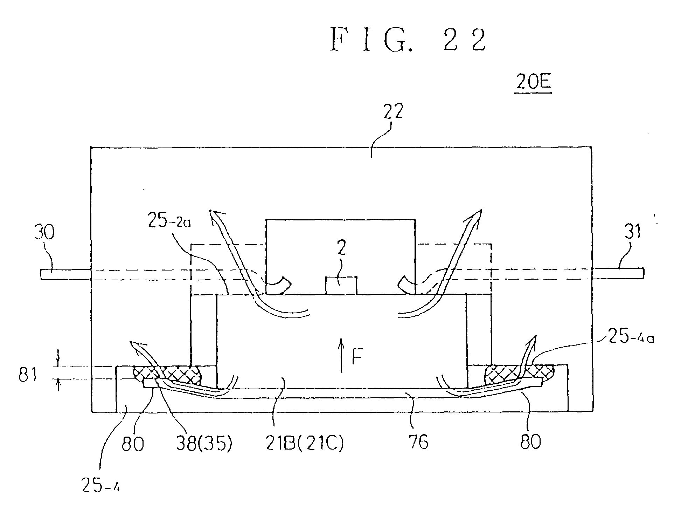

Fig. 22 shows a laser diode assembly 20E according to a sixth embodiment of the present invention.

Referring to Fig. 22, the laser diode assembly 20E includes the metal sheet 76 which is attached to the case 22 in an elastically deformed state. Thus, a gap 81 is formed which is smaller than the previously-described gap 79.

The subcarrier member 21 is urged in the upward direction in an abutting engagement with the reference surface 25₋₂ₐ by a force F exerted by the metal sheet 76 as a result of the elastic deformation. The abutting engagement can therefore be maintained even when the braze alloy or adhesive 38 causes a thermal expansion.

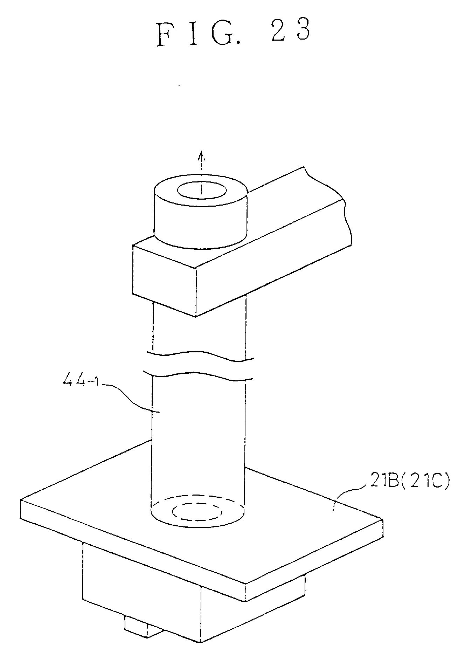

Fig. 23 shows a manipulation hand 44₋₁ that is used in the assembly jig 40. The hand 44₋₁ holds the metal sheet 76 by suction on one surface thereof at a side opposite to the side on which the subcarrier member is attached.

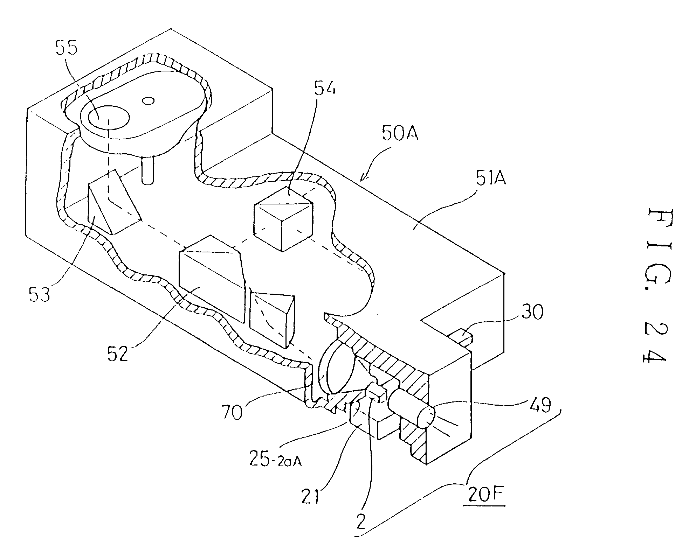

Fig. 24 shows a laser diode assembly 20F according to a seventh embodiment of the present invention.

Referring to Fig. 24, the case 22 of the laser diode assembly 20F may be used by a host apparatus 50A as well as by the laser diode assembly 20F. In other words, the host apparatus 50A has a case 51A used also as the case 22 of the laser diode assembly 20F. The case 51A is formed with a surface 25_{-2aA}, which is used as the second reference surface for positioning the subcarrier 21 of the laser diode assembly 20F with respect to the host apparatus 50A.

The construction of Fig. 5, that uses adhesive, may be used to mount the subcarrier 21 on the case 51A. Alternatively, the previously-described metal sheet 76 may be used to mount the subcarrier 21 on the case 51A of the host apparatus 50A similarly to the embodiment described with reference to Fig. 22. As modification of the present embodiment in view of the construction of Fig. 22 will be readily apparent, further description will be omitted.

## Claims

1. An optical semiconductor apparatus (20), adapted for mounting on an external apparatus, comprising:
a case (22) having a first surface (23) adapted for engagement with said external apparatus, a second surface (25₋₂ₐ) which is parallel to the first surface and separated from the said first surface (23) by a distance, and a cavity (25) formed by a depression (25₋₃) on said second surface;
a subcarrier member (21) having a principal surface; and
a laser diode (2) mounted on the said principal surface of the said subcarrier member (21) for producing an optical beam;
the said subcarrier member (21) being mounted in the semiconductor apparatus such that the said principal surface thereof is held in an abutting relationship with the said second surface (25₋₂ₐ) of the said case (22), and the said laser diode (2) is accommodated within said cavity (25);
characterised in that the laser diode (2) is arranged on the subcarrier member (21) such that the laser beam is emitted parallel to the said principal surface; and in that said distance is predetermined and chosen such that a desired distance of the laser diode (2) from the said first surface (23) is automatically achieved when the said subcarrier member (21) is mounted on the said second surface (25₋₂ₐ); and in that the structure of the case (22) and the cavity (25) are such that the said subcarrier member (21) is movable in a direction parallel to the said principal surface thereof during such positioning of the laser diode (2), while said principal surface is held in abutting engagement with the said second surface (25₋₂ₐ) for accurately positioning the laser diode (2).

2. Apparatus as claimed in claim 1, wherein the said case (22) is of cuboid shape and has upper and lower surfaces, one of which forms the said first surface (23), and wherein the cavity (25) formed in the case (22) is a stepped cavity having a further depression (25₋₂) with said depression (25₋₃) for accommodating the laser diode (2) being formed in correspondence to the central part of another depression (25₋₂) such that the said second surface (25₋₂ₐ) bounds the said further depression (25₋₂) on one side and the said subcarrier member (21) is accommodated within the further depression (25₋₂) thereof.

3. Apparatus as claimed in claim 1 or 2, wherein the said case (22) has a passage (28) through which an optical beam produced by the said laser diode (2) when the apparatus is in use may pass, and across which there is an optical element.

4. Apparatus as claimed in claim 1, 2, or 3, wherein a resilient electrode (31) protrudes into the said depression (25₋₃) in which the said laser diode (2) is accommodated, and is held in resilient contact with the said principal surface of the subcarrier member (21).

5. Apparatus as claimed in any one of claims 1 to 4, wherein the said subcarrier member (21) includes a metal plate (76) located on a surface of the subcarrier member (21) opposite to the said principal surface thereof, which metal plate (76) is larger in the plane of the principal surface than the subcarrier member, and is attached to the said case (22).

6. Apparatus as claimed in claim 5, wherein the said metal plate (76) is held in a resiliently-deformed state when the said subcarrier member (21) is in position and that metal plate (76) is attached to the said case (22).

7. A method of producing an optical semiconductor apparatus adapted for mounting on an external apparatus, which method comprises the steps of:
forming, on a case (22) having a first surface (23) for engagement with said external apparatus, a second surface (25₋₂ₐ), which is parallel to the first surface (23) and separated from the said first surface (23) by a distance, and a cavity (25) formed by a depression (25₋₃) on said second surface;
attaching a laser diode (2) for producing an optical beam to a principal surface of a subcarrier member (21); and
attaching the said subcarrier member (21) to the case (22) such that the said principal surface thereof is held in an abutting relationship with the said second surface (25₋₂ₐ) of the said case (22) and the said laser diode (2) is accommodated within the cavity (25₋₃);
characterised in that the laser diode (2) is attached such that the optical beam is emitted parallel to the said principal surface; and in that said distance is predetermined and chosen such that a desired distance of the laser diode (2) from the said first surface (23) is automatically achieved when the subcarrier member (21) is mounted on the said second surface (25₋₂ₐ); and in that the said first and second surfaces (23, 25₋₂ₐ) of the case (22) serve as reference surfaces for use in accurately positioning the laser diode (2), when attached to the said subcarrier member (21), in the semiconductor apparatus prior to attachment of the said subcarrier member (21) to the said case (22);
the method being further characterised by the additional steps, carried out between the steps of attaching the laser diode (2) to the subcarrier member (21) and attaching the subcarrier member (21) to the case (22), of:
energizing the said laser diode (2) so that an optical beam is produced thereby; and
adjusting the position of the said subcarrier member (21), while maintaining the said principal surface in abutting engagement with the said second surface (25₋₂ₐ), until the said optical beam travels along a predetermined path.

## Patentansprüche

1. Optische Halbleitervorrichtung (20) angepaßt zum Anbringen an einer externen Vorrichtung, umfassend:
ein Gehäuse (22) mit einer ersten Fläche (23), adaptiert zum Eingriff mit der externen Vorrichtung, einer zweiten Fläche (25₋₂ₐ), welche parallel zur ersten Fläche liegt und von der ersten Fläche (23) um eine Distanz getrennt ist, und einer Höhlung (25), die durch eine Vertiefung (25₋₃) in der zweiten Fläche gebildet ist;
ein Unterträgerelement (21) mit einer Hauptfläche; und
eine an der Hauptfläche des Unterträgerelements (21) angebrachte Laserdiode (2), zur Erzeugung eines optischen Strahl;
wobei das Unterträgerelement (21) derart an der Halbleitervorrichtung angebracht ist, daß dessen Hauptfläche in Angrenzbeziehung mit der zweiten Hauptfläche (25₋₂ₐ) des Gehäuses (22) gehalten wird und die Laserdiode (2) in der Höhlung (25) untergebracht ist;
dadurch gekennzeichnet, daß die Laserdiode (2) derart auf dem Unterträgerelement (21) angeordnet ist, daß der Laserstrahl parallel zur Hauptfläche emittiert wird; daß die Distanz derart vorbestimmt und gewählt ist, daß beim Anbringen des Unterträgerelements (21) an der zweiten Fläche (25₋₂ₐ) automatisch eine gewünschte Distanz der Laserdiode (2) zur ersten Fläche (23) erreicht wird; und daß die Struktur des Gehäuses (22) und die Höhlung (25) derart beschaffen sind, daß das Unterträgerelement (21) während eines derartigen Positionierens der Laserdiode (2) in einer zu dessen Hauptfläche parallelen Richtung bewegbar ist, während die Hauptfläche mit der zweiten Fläche (25₋₂ₐ) zum genauen Positionieren der Laserdiode (2) in Stoßeingriff gehalten wird.

2. Vorrichtung nach Anspruch 1, bei der das Gehäuse (22) von quaderartiger Form ist und eine obere und eine untere Fläche aufweist, von welchen eine die erste Fläche (23) bildet, und bei der die in dem Gehäuse (22) ausgebildete Höhlung (25) eine gestufte Höhlung mit einer weiteren Vertiefung (25₋₂) ist, wobei die Vertiefung (25₋₃) zum Unterbringen der Laserdiode (2) in Entsprechung zum Mittelabschnitt einer weiteren Vertiefung (25₋₂) ausgebildet ist, so daß die zweite Fläche (25₋₂ₐ) an die weitere Vertiefung (25₋₂) an einer Seite angrenzt und das Unterträgerelement (21) in der weiteren Vertiefung (25₋₂) davon untergebracht ist.

3. Vorrichtung nach Anspruch 1 oder 2, wobei das Gehäuse (22) einen Durchgang (28) aufweist, durch welchen ein bei Betrieb der Vorrichtung durch die Laserdiode (2) erzeugter optischer Strahl hindurchtreten kann und über welchem ein optisches Element vorgesehen ist.

4. Vorrichtung nach Anspruch 1, 2 oder 3, wobei eine Federelektrode (31) in die die Laserdiode (2) aufnehmende Vertiefung (25₋₃) hineinragt und in Federkontakt mit der Hauptfläche des Unterträgerelements (21) gehalten wird.

5. Vorrichtung nach einem der Ansprüche 1 bis 4, wobei das Unterträgerelement (21) eine auf einer Fläche des Unterträgerelements (21) gegenüber dessen Hauptfläche befindliche Metallplatte (76) umfaßt, welche in der Ebene der Hauptfläche größer ist als das Unterträgerelement und am Gehäuse (22) befestigt ist.

6. Vorrichtung nach Anspruch 5, wobei die Metallplatte (76) in einem Zustand elastischer Verformung gehalten wird, wenn das Unterträgerelement (21) in Position ist, und die Metallplatte (76) am Gehäuse (22) befestigt ist.

7. Verfahren zur Herstellung einer optischen Halbleitervorrichtung, welche sich zur Anbringung an einer externen Vorrichtung angepaßt ist, wobei das Verfahren folgende Schritte umfaßt:
Ausbilden, an einem Gehäuse (22), das eine erste Fläche (23) zum Eingriff mit der externen Vorrichtung hat, einer zweiten Fläche (25₋₂ₐ), die parallel zur ersten Fläche (23) verläuft und von der ersten Fläche (23) um eine Distanz getrennt ist, und einer durch eine Vertiefung (25₋₃) auf der zweiten Fläche ausgebildeten Höhlung (25);
Befestigen einer Laserdiode (2), zur Erzeugung eines optischen Strahl, an einer Hauptfläche eines Unterträgerelements (21); und
Befestigen des Unterträgerelements (21) an dem Gehäuse (22), so daß dessen Hauptfläche in Angrenzbeziehung mit der zweiten Fläche (25₋₂ₐ) des Gehäuses (22) gehalten wird und die Laserdiode (2) in der Höhlung (25₋₃) untergebracht ist;
dadurch gekennzeichnet, daß die Laserdiode (2) derart befestigt ist, daß der optische Strahl parallel zur genannten Hauptfläche emittiert wird; daß die Distanz derart vorbestimmt und gewählt ist, daß eine gewünschte Distanz der Laserdiode (2) zur ersten Fläche (23) beim Anbringen des Unterträgerelements (21) an der zweiten Fläche (25₋₂ₐ) automatisch erreicht wird; und daß die erste und die zweite Fläche (23, 25₋₂ₐ) des Gehäuses (22) als Bezugsflächen zur Anwendung bei genauem Positionieren der Laserdiode (2), wenn diese am Unterträgerelement (21) befestigt ist, in der Halbleitervorrichtung vor einer Befestigung des Unterträgerelements (21) am Gehäuse (22) dienen;
wobei das Verfahren ferner durch die folgenden, zwischen den Schritten des Befestigens der Laserdiode (2) am Unterträgerelement (21) und des Befestigens des Unterträgerelements (21) am Gehäuse (22) ausgeführten zusätzlichen Schritte gekennzeichnet ist:
Erregen der Laserdiode (2), so daß dadurch ein optischer Strahl erzeugt wird; und
Einstellen der Position des Unterträgerelements (21) unter Beibehaltung des Stoßeingriffs der Hauptfläche mit der zweiten Fläche (25₋₂ₐ), bis der optische Strahl einem vorbestimmten Weg folgt.

## Revendications

1. Appareil à semiconducteur optique (20), destiné à être monté sur un appareil externe, comprenant :
un boîtier (22) qui possède une première surface (23) destinée à venir en contact avec ledit appareil externe, une deuxième surface (25₋₂ₐ) qui est parallèle à la première surface et est séparée de ladite première surface (23) d'une certaine distance, et une cavité (25) formée par un creux (25₋₃) sur ladite deuxième surface ;
un élément (21) de support auxiliaire possédant une surface principale ; et
une diode laser (2) montée sur ladite surface principale dudit élément de support auxiliaire (21) et destinée à produire un faisceau optique ;
ledit élément de support auxiliaire (21) étant monté dans l'appareil à semiconducteur de façon que ladite surface principale de celui-ci soit maintenue en appui avec ladite deuxième surface (25₋₂ₐ) dudit boîtier (22), et que ladite diode laser (2) soit logée à l'intérieur de ladite cavité (25) ;
caractérisé en ce que ladite diode laser (2) est disposée sur l'élément de support auxiliaire (21) de façon que le faisceau laser soit émis parallèlement à ladite surface principale ; en ce que ladite distance est prédéterminée et choisie de façon qu'une distance voulue entre la diode laser (2) et ladite première surface (23) soit automatiquement obtenue lorsque ledit élément de support auxiliaire (21) est monté sur ladite deuxième surface (25₋₂ₐ) ; et en ce que la structure du boîtier (22) et la cavité (25) sont telles que ledit élément de support auxiliaire (21) puisse être déplacé dans la direction parallèle à ladite surface principale de celui-ci pendant le positionnement de la diode laser (2), tandis que ladite surface principale est maintenue en appui avec ladite deuxième surface (25₋₂ₐ) afin de positionner avec précision la diode laser (2).

2. Appareil selon la revendication 1, où ledit boîtier (22) est de forme cuboïde et possède des surfaces supérieure et inférieure dont l'une forme ladite première surface (23), et où la cavité (25) formée dans le boîtier (22) est une cavité à échelons ayant un creux supplémentaire (25₋₂), ledit creux (25₋₃) qui sert à loger la diode laser (2) étant formé en correspondance avec la partie centrale d'un autre creux (25₋₂) de façon que ladite deuxième surface (25₋₂ₐ) limite ledit creux supplémentaire (25₋₂) d'un côté et que ledit élément de support auxiliaire (21) soit logé à l'intérieur du creux supplémentaire (25₋₂) de celle-ci.

3. Appareil selon la revendication 1 ou 2, où ledit boîtier (22) possède un passage (28) par lequel un faisceau optique produit par ladite diode laser (2) lorsque l'appareil est en utilisation peut passer, et sur lequel il y a un élément optique.

4. Appareil selon la revendication 1, 2 ou 3, où une électrode élastique (31) fait saillie dans ledit creux (25₋₃) dans lequel est logée ladite diode laser (2), et est maintenue en contact élastique avec ladite surface principale dudit élément de support auxiliaire (21).

5. Appareil selon l'une quelconque des revendications 1 à 4, où ledit élément de support auxiliaire (21) comporte une plaque métallique (76) placée sur une surface de l'élément de support auxiliaire (21) qui est opposée à ladite surface principale de celui-ci, laquelle plaque métallique (76) est plus grande, dans le plan de la surface principale, que l'élément de support auxiliaire, et est fixée audit boîtier (22).

6. Appareil selon la revendication 5, où ladite plaque métallique (76) est maintenue dans un état de déformation élastique lorsque ledit élément de support auxiliaire (21) est en place et que la plaque métallique (76) est fixée audit boîtier (22).

7. Procédé de production d'un appareil à semiconducteur optique destiné à être monté sur un appareil externe, lequel procédé comprend les opérations suivantes :
former, sur un boîtier (22) qui possède une première surface (23) destinée à venir en contact avec ledit appareil externe, une deuxième surface (25₋₂ₐ), qui est parallèle à la première surface (23) et est séparée de ladite première surface (23) d'une certaine distance, et une cavité (25) formée par un creux (25₋₃) sur ladite deuxième surface ;
fixer une diode laser (2), destinée à produire un faisceau optique, à une surface principale d'un élément de support auxiliaire (21); et
fixer ledit élément de support auxiliaire (21) au boîtier (22) de façon que ladite surface principale de celui-ci soit maintenue en appui avec ladite deuxième surface (25₋₂ₐ) dudit boîtier (22) et que ladite diode laser (2) soit logée à l'intérieur de la cavité (25₋₃) ;
caractérisé en ce que la diode laser (2) est fixée de façon que le faisceau optique soit émis parallèlement à ladite surface principale ; en ce que ladite distance soit prédéterminée et choisie de façon qu'une distance voulue entre la diode laser (2) et ladite première surface (23) soit automatiquement obtenue lorsque l'élément de support auxiliaire (21) est monté sur ladite deuxième surface (25₋₂ₐ) ; et en ce que lesdites première et deuxième surfaces (23, 25₋₂ₐ) du boîtier (22) font fonction de surfaces de référence destinées à être utilisées dans le positionnement précis de la diode laser (2), une fois celle-ci fixée audit élément de support auxiliaire (21), dans l'appareil à semiconducteur avant la fixation dudit élément de support auxiliaire (21) audit boîtier (22) ;
le procédé étant en outre caractérisé par des opérations supplémentaires, effectuées entre les opérations qui consistent à fixer la diode laser (2) à l'élément de support auxiliaire (21) et à fixer l'élément de support auxiliaire (21) au boîtier (22), les opérations supplémentaires étant les suivantes :
exciter ladite diode laser (2) de façon qu'un faisceau optique soit produit par celle-ci ; et
ajuster la position dudit élément de support auxiliaire (21), tout en maintenant ladite surface principale en appui avec ladite deuxième surface (25₋₂ₐ), jusqu'à ce que ledit faisceau optique se déplace suivant un trajet prédéterminé.
